# FASCICULE DE BREVET EUROPEEN

(11) **EP 1 317 786 B1**
(45) Date de publication et mention de la délivrance du brevet: **18.01.2006**
(21) Numéro de dépôt: 01960053.5
(22) Date de dépôt: 10.09.2001
(51) Int. Cl.: H01S 5/34

(54) **LASER A CASCADES QUANTIQUES A EXCITATION PAR DES PHONONS OPTIQUES**
QUANTENKASKADENLASER MIT ANREGUNG DURCH OPTISCHE PHONONEN
QUANTUM CASCADE LASER WITH OPTICAL PHONON EXCITATION

(30) Priorité: 13.09.2000 EP 00810823
(43) Date de publication de la demande: 11.06.2003
(73) Titulaire: Alpes Lasers S.A., 2000 Neuchâtel (CH)
(72) Inventeur: FAIST, Jérôme, CH-2072 St.-Blaise (CH); BECK, Mattias, CH-4054 Basel (CH); MULLER, Antoine, CH-2000 Neuchâtel (CH)
(74) Mandataire: GLN
(86) Numéro de dépôt international: PCT/CH2001/000543
(87) Numéro de publication internationale: WO 2002/023686

(56) Documents cités:
- EP-A- 0 964 488
- FAIST J ET AL: "BISTRIBUTED FEEDBACK QUANTUM CASCADE LASERS" APPLIED PHYSICS LETTERS,AMERICAN INSTITUTE OF PHYSICS. NEW YORK,US, vol. 70, no. 20, 19 mai 1997 (1997-05-19), pages 2670-2672, XP000694785 ISSN: 0003-6951
- FAIST J ET AL: "Short wavelength ( lambda ~3.4 mu m) quantum cascade laser based on strained compensated InGaAs/AlInAs" APPLIED PHYSICS LETTERS, 9 FEB. 1998, AIP, USA, vol. 72, no. 6, pages 680-682, XP002159982 ISSN: 0003-6951
- LI Y G ET AL: "INTERSUBBAND ELECTROLUMINESCENCE IN GAAS/ALGAAS QUANTUM CASCADE STRUCTURES" ELECTRONICS LETTERS,GB,IEE STEVENAGE, vol. 33, no. 22, 23 octobre 1997 (1997-10-23), pages 1874-1875, XP000752360 ISSN: 0013-5194

## Description

La présente invention se rapporte aux lasers à cascades quantiques. Elle concerne plus particulièrement les lasers comportant deux électrodes pour appliquer un champ électrique de commande et un guide d'ondes disposé entre les deux électrodes et qui comprend:
- une région de gain formée de plusieurs couches qui comprennent, chacune une alternance de strates d'un premier type définissant chacune une barrière quantique et de strates d'un second type définissant chacune un puits quantique, ces strates étant constituées de premier et second matériaux semi-conducteurs, respectivement constitutifs des barrières et des puits, et
- deux couches de confinement optique disposées de part et d'autre de la région de gain,

Dans le présent document, on appelle "strate" une couche de faible épaisseur, présentant une certaine homogénéité dans sa composition, et "couche" un ensemble de strates assurant une même fonction.

Un laser de ce type est décrit dans le brevet US 5,457,709. Il est constitué de strates de premier et de second types, qui forment respectivement des barrières et des puits quantiques. Les matériaux constitutifs des barrières et des puits sont choisis de manière à ce qu'ils présentent une maille sensiblement égale à celle du substrat, de façon à conserver la structure monocristalline dans toute l'épaisseur du laser. EP 0 964 488 et Y.B.L; dans Electronics Letters, Vol. 33 n°12 du 23 octobre 1997 décrivent également des lasers de ce type.

La différence de potentiel cristallin des premier et second matériaux constituant respectivement les strates de premier et de second types définit, par effet de quantification, un ou plusieurs états bidimensionnels appelés sous-bandes.

Chacune des couches comporte une zone active et une zone de relaxation d'énergie. L'application d'un champ électrique aux bornes des électrodes engendre un courant de porteurs de charges à l'intérieur, notamment, de la région de gain.

L'émission d'un rayonnement laser est engendrée par la transition de porteurs de charges dans la zone active d'une première à une deuxième sous-bande. Ces porteurs de charge sont, en général, des électrons. Ce phénomène, appelé transition inter-sous-bandes, est accompagné de l'émission d'un photon.

Plus précisément, les puits de la zone active comportent, au moins, trois sous-bandes, appelées respectivement sous-bandes supérieure, médiane et inférieure. L'émission des photons se fait lors d'une transition entre les sous-bandes supérieure et médiane. Cette transition est rendue possible du fait que la population de la sous-bande médiane est réduite par transfert de ses électrons vers la sous-bande inférieure, avec émission d'un phonon optique. Pour qu'il puisse en être ainsi, il faut que l'énergie perdue par un porteur de charge passant de la sous-bande médiane à la sous-bande inférieure soit plus grande ou égale à celle des phonons optiques propre au matériau utilisé.

Le but principal de la présente invention est d'améliorer ce type de laser. A cet effet, chaque couche de la région de gain comporte une barrière d'injection et une zone active formée d'au moins trois paires de strates, chaque paire étant constituée d'une strate de premier et d'une strate de second type. Les strates de la zone active de chaque couche sont agencées de manière à ce que chacun des puits présente au moins une première sous-bande, supérieure, une deuxième sous-bande, médiane, et des troisième et quatrième sous-bandes, inférieures, la différence de potentiel entre les deuxième et troisième sous-bandes d'une part, les troisième et quatrième sous-bandes d'autre part, étant telle que la transition d'un électron de la deuxième à la troisième sous-bande, respectivement de la troisième à la quatrième, émet une énergie, dite correspondant à celle nécessaire pour l'émission d'un phonon optique du monocristal considéré.

De manière avantageuse, le laser selon l'invention comporte au moins quatre strates de second type.

Dans de tels lasers, les premier et second matériaux, respectivement constitutifs des barrières et des puits, sont déposés successivement, en veillant à ce que ceux-ci soient purs ou dopés de manière adéquate, chaque strate présentant une composition homogène, à l'exception des quelques couches atomiques attenantes aux strates voisines. En procédant ainsi, on obtient une succession de puits et de barrières présentant des flancs quasiment verticaux. Or, il a été constaté qu'aux interfaces de ces strates, les électrons avaient tendances à diffuser.

Plus précisément, l'étude faite par K. L. Campman et al., et publiée sous le titre "Interface roughness and alloy-disorder scattering contributions to intersubband transition linewidths" dans Appl. Phys. Letters 69 (17), 21 octobre 1996, a montré que les interfaces des strates ont une influence déterminante sur l'élargissement de la transition inter-sous-bandes, ce qui engendre une augmentation du courant de seuil.

Afin de réduire ce courant, et dans un mode de réalisation particulièrement intéressant, les strates de premier et de second types présentent respectivement des concentrations de 100% des premier et de second matériaux dans leur parties médianes, alors qu'entre deux parties médianes, les strates sont formées d'un alliage des deux matériaux dont la concentration varie de manière continue.

Généralement, le laser comporte un substrat, en phosphure d'indium (InP), sur lequel le différentes couches sont disposées.

Avec un substrat en InP, il est avantageux que le second matériau soit de l'InGaAs et le premier soit choisi parmi l'AlGaAs, l'InP et l'AllnAs.

Selon les applications, la longueur d'onde du rayonnement laser doit être plus ou moins courte. Une étude effectuée par J. Faist et al., intitulée "Short wavelength quantum cascade laser based on strained compensated InGaAs/AlInAs" et publiée dans Appl. Phys. Letters Vol. 72, No 6 du 9 février 1998, a montré qu'il est possible d'augmenter la différence de potentiel cristallin des deux matériaux constituant les strates et, en conséquence réduire la longueur d'onde des photons émis. C'est pourquoi, de manière avantageuse, les premier et second matériaux sont choisis de telle sorte qu'ils présentent des mailles l'un plus grandes, l'autre plus petites que celles du substrat.

Dans certaines applications, il est nécessaire de disposer d'un rayonnement présentant un spectre étroit d'émission. A cet effet, la couche de confinement opposée au substrat présente une structure définissant un réseau de diffraction de pas égal à un multiple de la moitié d'une longueur d'onde dans le cristal du spectre d'émission désiré.

D'autres avantages et caractéristiques de l'invention ressortiront de la description qui va suivre, faite en regard du dessin annexé, dans lequel:
- La figure 1 représente, de manière schématique, la structure d'un laser selon l'invention et, dans la partie agrandie, la représentation d'une couche de la région de gain, avec une barrière d'injection, une zone active et une zone de relaxation, et
- La figure 2 montre la variation du potentiel à l'intérieur de la zone active et les sous-bandes entre lesquelles transitent les électrons.
- La figure 3 donne, sous forme de courbes, des caractéristiques physiques obtenues au moyen d'un laser selon l'invention, et
- La figure 4 montre la variation de la composition chimique des strates dans une couche de la région active.

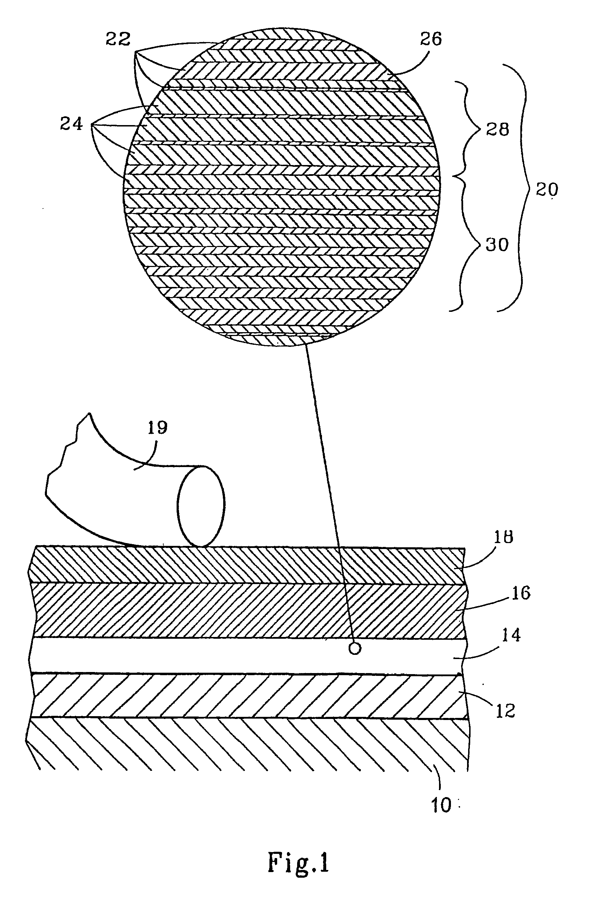

La figure 1 représente, schématiquement et à titre d'exemple, une coupe d'un laser à cascades quantiques selon l'invention, de type unipolaire et dans lequel les électrons sont les porteurs de charge.

Sur cette figure, les échelles relatives ne peuvent pas être respectées, à causes des épaisseurs particulièrement faibles de certaines couches. Le laser comporte un substrat 10 en phosphure d'indium (InP) monocristallin, tenant lieu d'électrode. Sur ce substrat 10 est disposé un guide d'ondes formé d'une première couche de confinement optique 12, d'une région de gain 14 à structure stratifiée, d'une seconde couche de confinement optique 16, et d'une électrode 18. Le substrat 10 est fixé sur un support non représenté au dessin. Un fil 19 est fixé sur l'électrode 18, généralement par soudure. L'alimentation du laser se fait en appliquant une tension entre le support et le fil 19.

Les couches de confinement optique 12 et 16 sont formées d'un alliage d'arséniure d'indium et de gallium (InGaAs), à raison de 52% d'arséniure d'indium et 48% d'arséniure de gallium. Une telle composition permet de définir une structure cristalline, de même maille et identique à celle de l'InP.

Ainsi qu'on peut le voir sur la partie agrandie de la figure 1, la région de gain 14 est constituée de couches successives 20, elles-mêmes formées de strates 22 d'un premier type et de strates 24 d'un second type, disposées en alternance. Chaque couche 20 comporte trois zones distinctes, soit une barrière d'injection 26, une zone active 28 et une zone d'injection et de relaxation 30.

Chacune des strates 22, qui forme une barrière quantique, est essentiellement constituée d'un alliage d'AllnAs, à raison de 53% molaire d'arséniure d'indium et 47% d'arséniure d'aluminium. Une telle composition engendre une structure cristalline identique à celle de l'InP.

Chacune des strates 24, qui forme un puits quantique, est essentiellement constituée d'un alliage d'InGaAs de même composition que les couches de confinement optique 12 et 16.

Un laser selon l'invention a été réalisé selon la structure exposée dans le tableau 1 ci-dessous.

**Tableau 1**

| **Référence** | **Matériau** | **Dopant** | **Niveau de dopage [cm**^{**-3**}**]** | **Epaisseur [nm]** |
|---|---|---|---|---|
| Substrat 10 | InP | Si | 1 - 5x10¹⁷ | massif |
| Couche confinement optique 12 | Ga_{0.5x}Al_{0.5(1-x)}InAs | | 2x10¹⁷ | 25 |
| | InGaAs | | 6x10¹⁶ | 200 |
| | Ga_{0.5x}Al_{0.5(1-x)}InAs | | 3X10¹⁷ | 12,4 |
| Région de gain 14 | 35 fois la structure du tableau 2 | | | 1816,5 |
| Couche de confinement optique 16 | InGaAs | | 6x10¹⁶ | 200 |
| | Ga_{0.5x}Al_{0.5(1-x)} InAs | | 2x10¹⁷ | 30 |
| Electrode 18 | InP | | 1x10¹⁷ | 2500 |
| | InP | | 7x10¹⁸ | 850 |
| | InP | | 1x10²⁰ | 10 |

Des exemples des caractéristiques des couches de confinement optique 12 et 16 et de l'électrode 18 sont donnés de manière complète dans les demandes de brevets déposées sous les numéros PCT/CH 99/00572 (numéro de publication WO 0035060) et PCT/CH 00/00159 (numéro de publication WO 0059085) au nom de la demanderesse. C'est pourquoi, leurs structures ne seront pas précisées de manière plus détaillée.

Le tableau 2 donne la composition des strates formant une barrière d'injection 26 et une couche 20 de la région de gain 14, qui en comporte trente-cinq.

**Tableau 2**

| **Référence** | **Matériau** | **Dopant** | **Niveau de dopage [cm**^{**-3**}**]** | **Epaisseur [nm]** |
|---|---|---|---|---|
| Barrière d'injection 26 | AllnAs | | | 4,0 |
| Zone active 28 | InGaAs | | | 1,9 |
| | AlInAs | | | 0,7 |
| | InGaAs | | | 5,8 |
| | AlInAs | | | 0,9 |
| | InGaAs | | | 5,7 |
| | AllnAs | | | 0,9 |
| | InGaAs | | | 5,0 |
| | AllnAs | | | 2,2 |
| Zone de relaxation et d'injection 30 | InGaAs | | | 3,4 |
| | AllnAs | | | 1,4 |
| | InGaAs | | | 3,3 |
| | AllnAs | | | 1,3 |
| | InGaAs | Si | 3.10¹⁷ | 3,2 |
| | AllnAs | Si | 3.10¹⁷ | 1,5 |
| | InGaAs | Si | 3.10¹⁷ | 3,1 |
| | AllnAs | Si | 3.10¹⁷ | 1,9 |
| | InGaAs | | | 3,0 |
| | AllnAs | | | 2,3 |
| | InGaAs | | | 2,9 |
| | AllnAs | | | 2,5 |
| | InGaAs | | | 2,9 |

La barrière 26 est donc formée d'une seule strate, de premier type, la zone active 28 de quatre strates de chaque type, et la zone de relaxation et d'injection 30 de six strates de premier type et sept de second type.

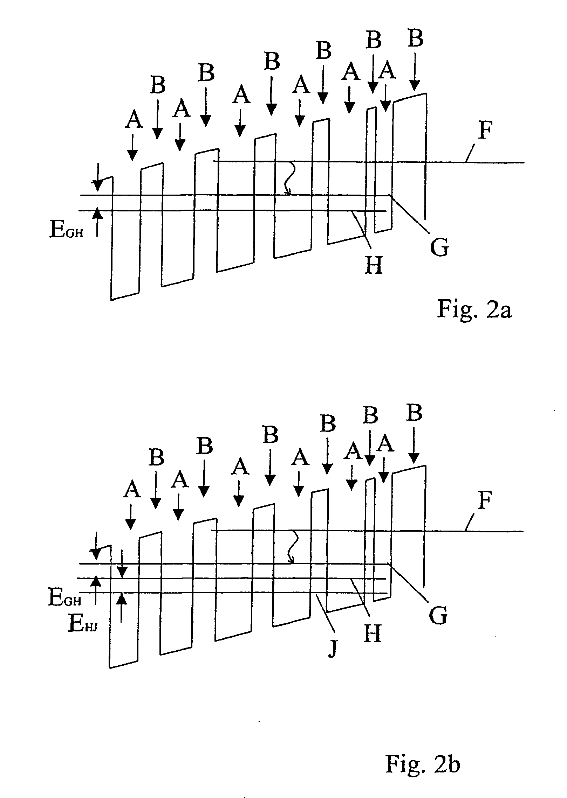

Dans ce laser, le potentiel à l'intérieur de la zone active, en présence d'un champ électrique d'excitation, varie comme représenté sur la figure 2. Ce potentiel présente une structure en créneaux, avec des creux A correspondant aux strates de premier type, les créneaux B les séparant correspondant aux barrières.

Dans les lasers connus, notamment par le brevet US 5,457,709 mentionné plus haut, l'extraction des électrons se fait par une résonance avec un phonon optique. Dans ces lasers et comme le montre le schéma a de la figure 2, les électrons peuvent occuper plusieurs sous-bandes dans chaque puits, soit une sous-bande supérieure F, une sous-bande médiane G et une sous-bande inférieure H.

La sous-bande supérieure F correspond au potentiel d'injection des électrons. C'est de cette sous-bande que partent les électrons actifs. Ces derniers engendrent un rayonnement laser en passant dans la sous-bande médiane G. Pour que l'émission puisse se faire, il est nécessaire que la population de la sous-bande supérieure F soit plus nombreuse que celle de la population de la sous-bande médiane G, ce qui peut être obtenu par résonance avec un phonon optique. Cette résonance peut être obtenue à condition que la différence de potentiel entre la sous-bande médiane G et la sous-bande inférieure H corresponde, pour un électron qui transite, à une perte d'énergie E_{GH} sensiblement égale à l'énergie des phonons optiques émis par le monocristal considéré, égale à 34 meV dans un monocristal constitué des matériaux mentionné dans les tableaux 1 et 2.

Le résultat peut être bien supérieur en utilisant une résonance avec deux phonons, par exemple avec une configuration telle que représentée sur le schéma b de la figure 2. Dans cette configuration, les électrons peuvent, en outre, occuper une quatrième sous-bande J, appelée deuxième sous-bande inférieure, la différence de potentiel entre les première et deuxième sous-bandes inférieures H et J correspondant, pour un électron qui transite, à une perte d'énergie E_{HJ} qui est sensiblement égale à E_{GH} et en conséquence, à l'énergie des phonons optiques émis.

Trois types de transitions avec émission de phonons optiques sont possibles, soit:
- Une transition de la sous-bande G à la sous-bande H, avec émission d'un phonon optique;
- Une transition de la sous-bande H à la sous-bande J, avec émission d'un phonon optique;
- Une transition de la sous-bande G à la sous-bande J, avec émission de deux phonons optiques.

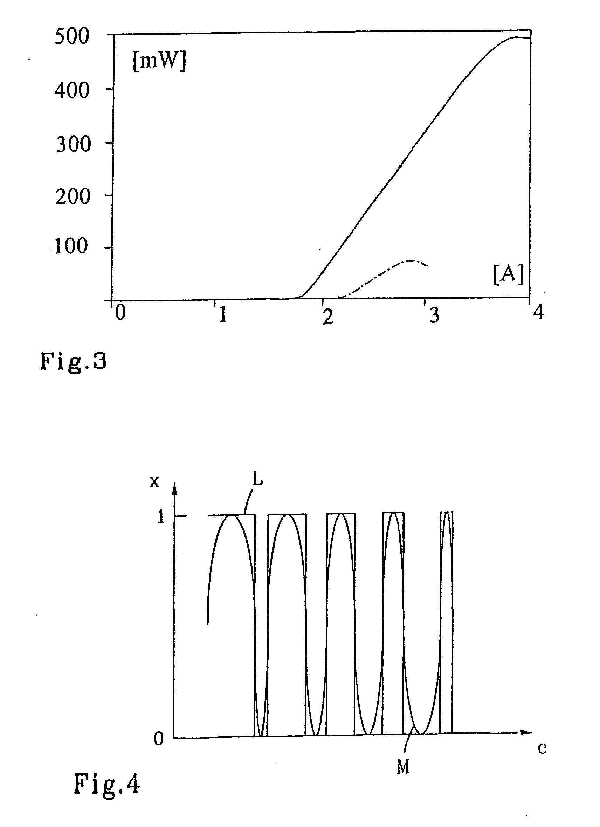

Toutes ces transitions permettent de réduire, de manière sensible, la population de la sous-bande G, ce qui renforce l'inversion de population et améliore, en conséquence, le fonctionnement du laser. Cette amélioration est illustrée sur la figure 3, qui représente deux courbes montrant comment varie la puissance fournie [mW] en fonction du courant [A], en traits pleins pour le laser selon l'invention et en traits mixtes pour le laser correspondant au mode de réalisation décrit dans Appl. Phys. Letters, volume 75 numéro 11 du 13 septembre 1999 dans une publication intitulée "Electrically tunable, room-temperature quantum-cascade lasers" (A. Müller et al.) Les deux lasers comparés sont de même taille, mesurés à une même température de 30°C et émettent dans des longueurs d'ondes voisines. Le tableau ci-dessous permet de comparer les résultats obtenus.

**Tableau 3**

| | Etat de la technique | Invention |
|---|---|---|
| Courant de seuil [A] | 2,2 | 1,8 |
| Puissance maximale fournie [mW] | 80 | 440 |

Il apparaît, tant à la lecture du tableau que de la figure 3, que le laser selon l'invention présente un rendement nettement supérieur et peut, en outre, fournir une puissance beaucoup plus grande avec de mêmes dimensions.

Le laser selon l'invention peut être amélioré en modifiant la composition chimique des strates dans la région dé gain, comme le montre la figure 4. Sur cette figure, il est considéré que la composition chimique répond à la formule Gaₓ Al₍₁₋ₓ₎ InAs, dans laquelle x varie de 0 à 1, selon la position considérée dans l'épaisseur de la couche. L'abscisse se rapporte à l'épaisseur e de la structure et l'ordonnée à x. La courbe L montre la variation de la composition telle qu'elle se présente dans les lasers selon l'état de la technique ainsi que dans l'exemple donné plus haut, alors que la courbe M se rapporte à un mode particulier de réalisation.

Pour réaliser une structure ayant une composition correspondant à la courbe L, les matériaux (InGaAs et AlInAs) sont déposés successivement. En procédant ainsi, les puits et les barrières forment des flancs quasiment verticaux, la diffusion entre strates étant faible. Il a été constaté qu'aux interfaces de ces strates, les électrons avaient tendance à diffuser, comme expliqué par K. L. Campman et al., dans son article cité plus haut.

Une composition de la couche telle que correspondant à la courbe M permet de pallier cet inconvénient. Cette courbe présente une forme avec des maxima dans les parties médianes des strates, la composition variant de manière continue entre deux parties médianes.

Il est, notamment, possible de réaliser une couche telle que celle représentée par la courbe M en alternant de manière plus fréquente les dépôts de InGaAs et AllnAs, l'épaisseur de chaque dépôt représentant une portion de strate, correspondant à quelques couches atomiques.

Dans certaines applications, il est nécessaire de disposer d'un spectre étroit d'émission de la lumière. Cette condition peut être satisfaite avec une couche de confinement supérieure, c'est-à-dire disposée du côté opposé au substrat, qui présente une structure définissant un réseau de diffraction de pas égal à un multiple de la longueur d'onde, dans le monocristal, du spectre d'émission désiré. L'obtention d'un tel réseau fait l'objet de la demande de brevet déposée sous le numéro PCT/CH 00/0159 (numéro de publication WO 0059085) sous le titre "Laser semi-conducteur infrarouge", au nom de la demanderesse.

Le laser à cascades quantiques selon l'invention peut faire l'objet de nombreuses variantes, sans pour autant sortir du cadre de l'invention. D'autres matériaux que le AlInAs peuvent constituer les barrières, par exemple l'InP ou l'AlGaAs. Le nombre de strates et leurs épaisseurs peuvent aussi considérablement varier.

## Revendications

1. Laser à cascades quantiques comportant deux électrodes (10, 18), pour appliquer un champ électrique de commande, et un guide d'ondes disposé entre les deux électrodes et qui comprend:
• une région de gain (14) formée de plusieurs couches (20) qui comprennent, chacune une alternance de strates (22) d'un premier type définissant chacune une barrière quantique et de strates (24) d'un second type définissant chacune un puits quantique, ces strates étant constituées de premier et second matériaux semi-conducteurs, respectivement constitutifs des barrières et des puits, et
• deux couches de confinement optique (12, 16) disposées de part et d'autre de la région de gain (14),
**caractérisé en ce que** chaque couche (20) de la région de gain (14) comporte une barrière d'injection (26) et une zone active (28) formée d'au moins trois paires de strates, chaque paire étant formée d'une strate de premier (22) et d'une strate de second type (24), et **en ce que** les strates de la zone active de chaque couche sont agencées de manière à ce que chacun des puits présente au moins une première sous-bande (F), supérieure, une deuxième sous-bande (G), médiane, et des troisième (H) et quatrième (J) sous-bandes, inférieures, la différence de potentiel entre les deuxième et troisième sous-bandes d'une part, les troisième et quatrième sous-bandes d'autre part, étant telle que la transition d'un électron de la deuxième à la troisième sous-bande, respectivement de la troisième à la quatrième, émet une énergie (E_{GH}, E_{HJ}) correspondant à celle nécessaire pour l'émission d'un phonon optique.

2. Laser selon la revendication 1, **caractérisé en ce que** ladite zone (28) comporte au moins quatre strates de second type.

3. Laser selon l'une des revendications 1 et 2, **caractérisé en ce que** les strates de premier (22) et de second types (24) présentent respectivement des concentrations de 100% des premier et de second matériaux dans leur parties médianes, alors qu'entre deux parties médianes, les strates sont formées d'un alliage desdits deux matériaux, dont les concentrations varient de manière continue.

4. Laser selon l'une des revendications 1 à 3, **caractérisé en ce qu'**il comporte, en outre, un substrat (10), sur lequel sont disposées lesdites couches (20).

5. Laser selon la revendication 4, **caractérisé en ce que** ledit substrat (10) est en phosphure d'indium InP.

6. Laser selon la revendication 5, **caractérisé en ce que** le second matériau est de l'InGaAs et le premier est choisi parmi l'AlGaAs, l'InP et l'AlInAs.

7. Laser selon l'une des revendications 4 à 6, **caractérisé en ce que** lesdits premier et second matériaux sont choisis de manière à ce qu'ils présentent des mailles l'un plus grandes, l'autre plus petites que celles dudit substrat.

8. Laser selon l'une des revendications 4 à 7, **caractérisé en ce que** la couche de confinement (16) opposée audit substrat (10) présente une structure définissant un réseau de diffraction de pas égal à un multiple de la moitié d'une longueur d'onde dans le cristal du spectre d'émission désiré.

## Claims

1. A quantum cascade laser comprising two electrodes (10, 18), for applying an electric control field, and a waveguide placed between the two electrodes and which comprises:
• a gain region (14) consisting of several layers (20) which each comprise alternating strata (22) of a first type each defining a quantum barrier and strata (24) of a second type each defining a quantum well, these strata consisting of first and second semiconductor materials, respectively forming barriers and wells, and
• two optical confinement layers (12, 16) placed on each side of the gain region (14),
**characterized in that** each layer (20) of the gain region (14) has an injection barrier (26) and an active region (28) formed from at least three pairs of strata, each pair consisting of a stratum of the first (22) type and a stratum of the second (24) type, and **in that** the strata of the active region of each layer are arranged so that each of the wells has at least a first upper subband (F), a second middle subband (G), and third (H) and fourth (J) lower subbands, the potential difference between the second and third subbands, on the one hand, and the third and fourth subbands, on the other hand, being such that the transition of an electron from the second to the third subband, or the third to the fourth, emits an energy (E_{GH}, E_{HJ}) corresponding to that needed for the emission of an optical phonon.

2. The laser as claimed in claim 1, **characterized in that** said region (28) comprises at least four strata of the second type.

3. The laser as claimed in either of claims 1 and 2, **characterized in that** the strata of the first (22) and of the second (24) type respectively have concentrations of 100% of the first and of the second materials in their middle parts, while between two middle parts, the strata consist of an alloy of said two materials, the concentrations of which vary continuously.

4. The laser as claimed in one of claims 1 to 3, **characterized in that** it further comprises a substrate (10), on which said layers (20) are placed.

5. The laser as claimed in claim 4, **characterized in that** said substrate (10) is made of indium phosphide InP.

6. The laser as claimed in claim 5, **characterized in that** the second material is InGaAs and the first is chosen from AlGaAs, InP and AlInAs.

7. The laser as claimed in one of claims 4 to 6, **characterized in that** said first and second materials are chosen such that they have lattice parameters one of which is greater, the other of which is smaller than those of said substrate.

8. The laser as claimed in one of claims 4 to 7, **characterized in that** the confinement layer (16) opposite said substrate (10) has a structure defining a diffraction grating having a pitch equal to a multiple of a half wavelength in the crystal with the desired emission spectrum.

## Patentansprüche

1. Quantenkaskadenlaser, der zwei Elektroden (10, 18) zum Anlegen eines elektrischen Steuerfeldes und einen zwischen den beiden Elektroden angeordneten Wellenleiter umfasst, der seinerseits:
• einen Verstärkungsbereich (14), der aus mehreren Schichten (20) gebildet wird, die jeweils abwechslungsweise Lagen (22) eines ersten, jeweils eine Quantensperre bestimmenden, bzw. Lagen (24) eines zweiten, jeweils einen Quantentopf bildenden Typs umfassen, wobei diese Lagen aus ersten und zweiten, die Sperren respektive Töpfe bildenden Materialien bestehen, und
• zwei beidseitig des Verstärkungsbereichs (14) angeordnete optische Einschließungsschichten (12, 16) umfasst,
**dadurch gekennzeichnet, dass** jede Schicht (20) des Verstärkungsbereichs (14) eine Injektionssperre (26) und eine Aktivzone (28) umfasst, wobei letztere aus mindestens drei Lagenpaaren gebildet wird, die ihrerseits jeweils durch eine Lage eines ersten (22) und eines zweiten Typs (24) gebildet werden, und dass die Lagen der Aktivzone jeder der Schichten so beschaffen sind, dass jeder der Töpfe mindestens ein erstes oberes (F), ein zweites mittleres (G) sowie an unterster Stelle ein drittes (H) und ein viertes Unterband (J) aufweist, wobei einerseits zwischen dem zweiten und dritten und andererseits zwischen dem dritten und vierten Unterband eine solches Spannungsgefälle herrscht, dass der Übergang eines Elektrons vom zweiten zum dritten respektive vom dritten zum vierten Unterband eine Energie (E_{GH}, E_{HJ},) freisetzt, die jener entspricht, die zur Emission eines optischen Phonons erforderlich ist.

2. Laser nach Anspruch 1, **dadurch gekennzeichnet, dass** die besagte Zone (28) mindestens vier Lagen des zweiten Typs umfasst.

3. Laser nach einem der Ansprüche 1 und 2, **dadurch gekennzeichnet, dass** die Lagen des ersten (22) und des zweiten Typs (24) in ihrem mittleren Teil jeweils eine Konzentration von 100 Prozent des ersten bzw. des zweiten Materials aufweisen, während die Lagen zwischen zwei mittleren Teilen aus einer Legierung der beiden besagten Materialien gebildet werden, deren Konzentrationen auf kontinuierliche Weise variieren.

4. Laser nach einem der Ansprüche 1 bis 3, **dadurch gekennzeichnet, dass** er im Weiteren ein Substrat (10) umfasst, auf welchem die besagten Schichten (20) angeordnet sind.

5. Laser nach Anspruch 4, **dadurch gekennzeichnet, dass** das besagte Substrat (10) aus Indiumphosphid InP besteht

6. Laser nach Anspruch 5, **dadurch gekennzeichnet, dass** es sich bei dem zweiten Material um InGaAs handelt und das erste unter AlGaAs, InP und AllnAs ausgewählt wird.

7. Laser nach einem der Ansprüche 4 bis 6, **dadurch gekennzeichnet, dass** die besagten ersten und zweiten Materialien so gewählt werden, dass das eine größere und das andere kleinere Maschen als die des Substrats aufweist.

8. Laser nach einem der Ansprüche 4 bis 7, **dadurch gekennzeichnet, dass** die dem besagten Substrat (10) gegenüberliegende Einschließungsschicht (16) eine Struktur aufweist, die ein Beugungsgitter bestimmt, dessen Rastermaß dem Mehrfachen der Hälfte einer Wellenlänge im Kristall des gewünschten Emissionsspektrums entspricht.
